(19) Europäisches Patentamt
European Patent Office
Office européen des brevets

(11) Veröffentlichungsnummer : **0 496 698 A2**

(12) # EUROPÄISCHE PATENTANMELDUNG

(21) Anmeldenummer : **92810021.3**

(51) Int. Cl.$^5$ : **B32B 15/08**

(22) Anmeldetag : **14.01.92**

(30) Priorität : **22.01.91 CH 170/91**

(43) Veröffentlichungstag der Anmeldung :
**29.07.92 Patentblatt 92/31**

(84) Benannte Vertragsstaaten :
**BE CH DE FR GB IT LI NL**

(71) Anmelder : **CIBA-GEIGY AG**
**Klybeckstrasse 141**
**CH-4002 Basel (CH)**

(72) Erfinder : **Pfaendner, Rudolf, Dr.**
**Sackgasse 3**
**W-6149 Rimbach/Odenwald 1 (DE)**
Erfinder : **Scharf, Wolfgang, Dr.**
**Röttler Ring 11c**
**W-7889 Grenzach-Wyhlen (DE)**
Erfinder : **Kainmüller, Thomas, Dr.**
**Am Kümmelberg 1**
**W-6145 Lindenfels 1 (DE)**
Erfinder : **Haug, Theobald, Dr.**
**Untere Flühackerstrasse 12**
**W-4402 Frenkendorf (CH)**

(54) **Flexibile Laminate.**

(57) Laminate enthaltend mindestens eine Metallfolie und mindestens eine darauf direkt aufgebrachte Kunststoffschicht aus einer Zusammensetzung, die 98-60 Gew.% eines vorwiegend OH-terminierten Polyethersulfons mit einem Hydroxylgruppengehalt von mindestens 10 μval/g und 2-40 Gew.% eines mehrfunktionellen Epoxids enthält, zeichnen sich durch hohe Chemikalienbeständigkeit, gute flexible Eigenschaften und besonders hohe Haftfestigkeit aus und eignen sich zur Herstellung von elektronischen Schaltungen.

EP 0 496 698 A2

Die vorliegende Erfindung betrifft flexible Laminate auf Basis von Polyethersulfon/Epoxid-Zusammensetzungen sowie ein Verfahren zu deren Herstellung.

Polyethersulfone sind Werkstoffe mit sehr guten mechanischen und thermischen Eigenschaften, die, wie beispielsweise in der EP-A 89 387 beschrieben, zur Herstellung von flexiblen Laminaten verwendet werden können. Flexible Laminate müssen neben guten thermischen und elektrischen Eigenschaften eine gute Chemikalienbeständigkeit und vor allem eine hohe Flexibilität aufweisen, d.h. diese Verbundmaterialien sollten sehr oft gefaltet werden können, bevor es zu einem Bruch kommt.

Eine weitere wichtige Eigenschaft ist eine hohe Haftung zwischen dem Polymerfilm und der Metallfolie auch bei hohen Temperaturen. Die Haftung von Polyethersulfon auf Metall ist jedoch vielfach unbefriedigend. So werden beispielsweise in den JP-A 62/242530, 62/18430, 62/242529 und 54/129077 Polyethersulfon-Laminate beschrieben, die deshalb mittels einer Klebstoffschicht aufgebracht werden. Klebstoff-Zwischenschichten verlieren jedoch ihre gute Haftung bei erhöhten Temperaturen.

Als eine weitere Massnahme wird in der EP-A 315 851 zum Erzielen einer hohen Haftung die Verwendung einer Metallfolie mit vergrösserter Oberfläche vorgeschlagen. Die dort beschriebene oxidierte Kupferfolie führt zwar zu einer verbesserten Haftung, die jedoch noch nicht für alle Belange ausreichend ist. Ausserdem wird die Chemikalienbeständigkeit durch die beschriebenen Massnahmen nicht verbessert.

Es wurden nun Laminate auf Basis von Polyethersulfon/Epoxid-Zusammensetzungen entwickelt, die sich durch hohe Chemikalienbeständigkeit, gute flexible Eigenschaften und eine besonders hohe Haftung auszeichnen.

Gegenstand der vorliegenden Erfindung sind Laminate enthaltend mindestens eine Metallfolie und mindestens eine darauf direkt aufgebrachte Kunststoffschicht aus einer Zusammensetzung, die 2-40 Gew. % mindestens eines mehrfunktionellen Epoxids mit mindestens zwei direkt an ein oder mehrere Sauerstoff-, Stickstoff- oder Schwefelatome gebundenen Glycidylgruppen und 98-60 Gew.% mindestens eines vorwiegend OH-terminierten Polyethersulfons mit einem Hydroxylgruppengehalt von mindestens 10 µval/g, enthaltend wiederkehrende Strukturelemente der Formel (I), enthält

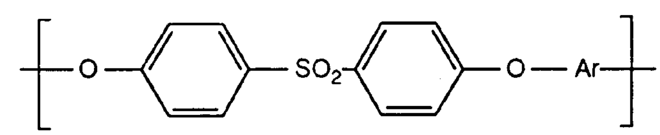 (I),

worin Ar für einen zweiwertigen aromatischen Rest der Formeln (IIa) bis (IIh) steht

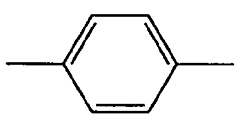 (IIa), 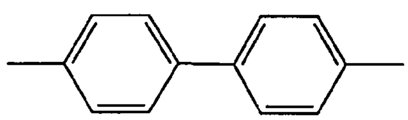 (IIb),

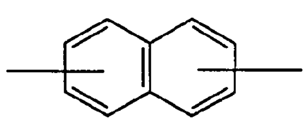 (IIc), 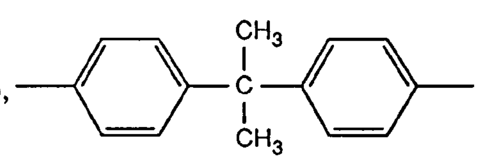 (IId),

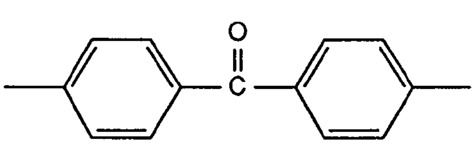 (IIe), 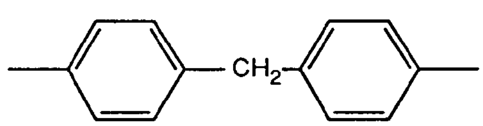 (IIf),

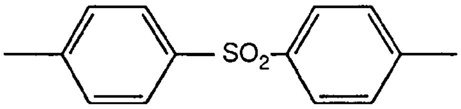 (IIg),

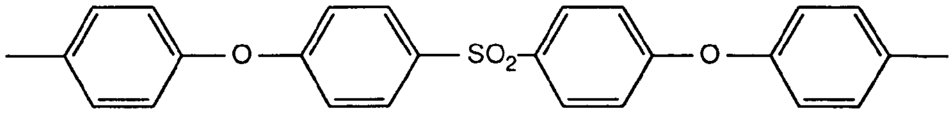 (IIh),

und worin die aromatischen Ringe der Strukturelemente gemäss Formel (I) oder (IIa)-(IIh) unsubstituiert sind oder durch eine oder mehrere ($C_1$-$C_6$)-Alkylgruppen, ($C_1$-$C_6$)-Alkoxygruppen oder Halogenatome substituiert sind.

Die erfindungsgemässe Kunststoffschicht ist vorzugsweise eine Zusammensetzung, die 4-20 Gew.%, insbesondere 5-15 Gew.%, eines mehrfunktionellen Epoxids und 96-80 Gew.%, insbesondere 95-85 Gew.%, eines Polyethersulfons enthält.

Bei bifunktionellen Epoxiden wird bevorzugt ein Verhältnis Polyethersulfon : Epoxid gewählt, das einen hohen Epoxidanteil aufweist; bei tri- und tetrafunktionellen Epoxiden wird bevorzugt ein Verhältnis gewählt, das einen niedrigen Epoxidanteil aufweist.

Das zu wählende Verhältnis ist ferner vom Molekulargewicht und der Zahl der vorhandenen Endgruppen abhängig. Bei einem Polyethersulfon mit niedrigem Molekulargewicht und einer hohen Zahl funktioneller Endgruppen wird bevorzugt ein Verhältnis gewählt, das einen hohen Epoxidanteil aufweist. Bei einem Polyethersulfon mit hohem Molekulargewicht wird ein Verhältnis gewählt, das einen niedrigen Epoxidanteil aufweist.

Gegebenenfalls kann auch ein Gemisch von Polyethersulfonen unterschiedlicher Struktur und/oder ein Gemisch von verschiedenen Epoxidharzen eingesetzt werden.

Polyethersulfone der Formel (I) sind beispielsweise aus der DE-OS 3 737 922 bekannt und zum Teil im Handel erhältlich. Beispiele für solche Polyethersulfone sind Victrex® PES (ICI), Ultrason® S (BASF), Radel® (Amoco) und Udel® (Amoco). Diese kommerziell erhältlichen Polyethersulfone enthalten jedoch keine oder nur sehr wenige OH-Endgruppen.

Der Rest Ar im Strukturelement der Formel (I) ist bevorzugt ein Rest der Formeln (IIa), (IIb), (IIc) oder (IIg). Besonders bevorzugt ist ein Rest der Formel (IIg).

Sind die aromatischen Ringe der Strukturelemente (I) und/oder (IIa)-(IIh) durch ($C_1$-$C_6$)-Alkylgruppen oder ($C_1$-$C_6$)-Alkoxygruppen substituiert, so handelt es sich dabei um verzweigte oder insbesondere um geradkettige Reste.

Beispiele für Alkylgruppen sind Methyl, Ethyl, n-Propyl, Isopropyl, n-Butyl, sek.-Butyl, tert.-Butyl, n-Pentyl und n-Hexyl.

Beispiele für Alkoxygruppen sind Methoxy, Ethoxy, n-Propoxy, Isopropoxy, n-Butoxy, tert.-Butoxy, n-Pentoxy und n-Hexoxy.

Sind die Reste der Formel (I) und/oder (IIa)-(IIh) durch Halogenatome substituiert, so handelt es sich dabei im allgemeinen um Fluor, Iod oder insbesondere um Chlor oder Brom.

Die aromatischen Ringe der Strukturelemente (I) und (IIa)-(IIh) sind vorzugsweise unsubstituiert.

In den erfindungsgemässen Laminaten kann als mehrfunktionelles Epoxid im Prinzip jede in der Technik der Epoxidharze übliche Verbindung eingesetzt werden.

Beispiele für Epoxidharze sind:

I) Polyglycidyl- und Poly(β-methylglycidyl)ester erhältlich durch Umsetzung einer Verbindung mit mindestens zwei Carboxylgruppen im Molekül und Epichlorhydrin bzw. β-Methylepichlorhydrin. Die Umsetzung erfolgt zweckmässig in der Gegenwart von Basen.

Als Verbindung mit mindestens zwei Carboxylgruppen im Molekül können aliphatische Polycarbonsäuren verwendet werden. Beispiele für diese Polycarbonsäuren sind Oxalsäure, Bernsteinsäure, Glutarsäure, Adipinsäure, Pimelinsäure, Korksäure, Azelainsäure oder dimerisierte bzw. trimerisierte Linolsäure.

Es können aber auch cycloaliphatische Polycarbonsäuren eingesetzt werden, wie beispielsweise Tetrahydrophthalsäure, 4-Methyltetrahydrophthalsäure, Hexahydrophthalsäure oder 4-Methylhexahydrophthalsäure.

Weiterhin können aromatische Polycarbonsäuren Verwendung finden, wie beispielsweise Phthalsäure,

Isophthalsäure oder Terephthalsäure.

II) Polyglycidyl- oder Poly(β-methylglycidyl)ether erhältlich durch Umsetzung einer Verbindung mit mindestens zwei freien alkoholischen Hydroxygruppen und/oder phenolischen Hydroxygruppen und Epichlorhydrin oder β-Methylepichlorhydrin unter alkalischen Bedingungen, oder in Anwesenheit eines sauren Katalysators und anschliessende Alkalibehandlung.

Ether dieses Typs leiten sich beispielsweise ab von acyclischen Alkoholen, wie Ethylenglykol, Diethylenglykol und höheren Poly(oxyethylen)glykolen, Propan- 1,2-diol oder Poly(oxypropylen)glykolen, Propan- 1,3-diol, Butan- 1,4-diol, Poly(oxytetramethylen)glykolen, Pentan- 1,5-diol, Hexan- 1,6-diol, Hexan-2,4,6-triol, Glycerin, 1,1,1-Trimethylolpropan, Pentaerythrit, Sorbit, sowie von Polyepichlorhydrinen.

Sie leiten sich aber auch beispielsweise ab von cycloaliphatischen Alkoholen, wie 1,4-Cyclohexandimethanol, Bis(4-hydroxycyclohexyl)methan oder 2,2-Bis(4-hydroxycyclohexyl)propan, oder sie besitzen aromatische Kerne, wie N,N-Bis(2-hydroxyethyl)anilin oder p,p′-Bis(2-hydroxyethylamino)diphenylmethan.

Die Epoxidverbindungen können sich auch von einkerningen Phenolen ableiten, wie beispielsweise von Resorcin oder Hydrochinon; oder sie basieren auf mehrkernigen Phenolen, wie beispielsweise Bis(4-hydroxyphenyl)methan, 4,4′-Dihydroxybiphenyl, Bis(4-hydroxyphenyl)sulfon, 1,1,2,2-Tetrakis(4-hydroxyphenyl)ethan, 2,2-Bis(4-hydroxyphenyl)propan oder 2,2-Bis(3,5-dibrom-4-hydroxyphenyl)propan, oder auf Novolaken erhältlich durch Kondensation von Aldehyden, wie Formaldehyd, Acetaldehyd, Chloral oder Furfuraldehyd, mit Phenolen, wie Phenol, oder mit Phenolen, die im Kern mit Chloratomen oder $C_1$-$C_9$-Alkylgruppen substituiert sind, wie beispielsweise 4-Chlorphenol, 2-Methylphenol oder 4-tert-Butylphenol, oder durch Kondensation mit Bisphenolen, so wie oben beschrieben.

III) Poly(N-glycidyl)verbindungen erhältlich durch Dehydrochlorierung der Reaktionsprodukte von Epichlorhydrin mit Aminen, die mindestens zwei Aminwasserstoffatome enthalten. Bei diesen Aminen handelt es sich zum Beispiel um Anilin, n-Butylamin, Bis(-4-aminophenyl)methan, m-Xylylendiamin oder Bis(4-methylaminophenyl)methan.

Zu den Poly(N-glycidyl)verbindungen zählen aber auch Triglycidylisocyanurat, N,N′-Diglycidylderivate von Cycloalkylenharnstoffen, wie Ethylenharnstoff oder 1,3-Propylenharnstoff, und Diglycidylderivate von Hydantoinen, wie von 5,5-Dimethylhydantoin.

IV) Poly(S-glycidyl)verbindungen, beispielsweise Di-S-glycidylderivate, die sich von Dithiolen, wie beispielsweise Ethan-1,2-dithiol oder Bis(4-mercaptomethylphenyl)ether ableiten.

V) Cycloaliphatische Epoxidharze, beispielsweise Bis(2,3-epoxycyclopentyl)ether, 2,3-Epoxycyclopentylglycidylether, 1,2-Bis(2,3-epoxycyclopentyloxy)ethan oder 3,4-Epoxycyclohexylmethyl-3′,4′-epoxycyclohexancarboxylat.

Es lassen sich aber auch Epoxidharze verwenden, bei denen die 1,2-Epoxidgruppen an unterschiedliche Heteroatome bzw. funktionelle Gruppen gebunden sind; zu diesen Verbindungen zählen beispielsweise das N,N,O-Triglycidylderivat des 4-Aminophenols, der Glycidylether-glycidylester der Salicylsäure, N-Glycidyl-N′-(2-glycidyloxypropyl)-5,5-dimethylhydantoin oder 2-Glycidyloxy-1,3-bis(5,5-dimethyl-1-glycidylhydantoin-3-yl)propan.

Die zu verwendenden Epoxidharze können auch durch Alkyl-, Alkenyl-, Aryl-, Alkoxyoder Aryloxygruppen oder Halogenatome substituiert sein. Ein bevorzugtes Beispiel für solche substituierten Epoxidharze ist o,o′-Diallylbisphenol-A-diglycidylether.

Bevorzugte Epoxidharze sind Bisphenol-A-diglycidylether, Bisphenol-F-diglycidylether, Bisphenol-S-diglycidylether, Resorcindiglycidylether, N,N,O-Triglycidyl-p-aminophenol, N,N,O-Triglycidyl-m-aminophenol, Triglycidylisocyanurat, Tetraglycidyl-4,4′-diaminodiphenylmethan und Tetra(p-glycidyloxyphenyl)ethan.

Bisphenol-A-diglycidylether, Bisphenol-F-diglycidylether, Triglycidylisocyanurat und Tetraglycidyl-4,4′-diaminodiphenylmethan sind besonders bevorzugt.

Ein weiteres bevorzugtes Epoxid ist o,o′-Diallylbisphenol-A-diglycidylether.

Als Metallfolie können die erfindungsgemässen Laminate beispielsweise solche aus Kupfer, Messing, Aluminium, Eisen oder Stahl enthalten. Vorzugsweise werden Kupferfolien verwendet.

Einen weiteren Erfindungsgegenstand bildet ein Verfahren zur Herstellung von Laminaten, dadurch gekennzeichnet, dass eine Polyethersulfon/Epoxid-Zusammensetzung, gelöstin einem organischen Lösungsmittel, auf eine Metallfolie aufgebracht und bei Temperaturen zwischen 100 °C und 300 °C, gegebenenfalls unter IR-Bestrahlung, getrocknet wird.

Die Beschichtung der Metallfolien mit den erfindungsgemäss in Frage kommenden Polyethersulfon/Epoxidharz-Zusammensetzungen kann mit Hilfe einer Lösung nach an sich bekannten Verfahren sowohl von Hand als auch mit üblichen Beschichtungsmaschinen vorgenommen werden. Bei der maschinellen Beschichtung ist es wichtig, dass eine klebfreie Polymerschicht auf der Metallfolie erhalten wird, so dass dieser Schichtstoff sich gewünschtenfalls aufrollen lässt.

Geeignete Lösungsmittel für die Polyethersulfon/Epoxidharz-Zusammensetzungen sind beispielsweise

polare aprotische Lösungsmittel wie N,N-Dimethylacetamid, N,N-Dimethylformamid, Dimethylsulfoxid, Sulfolan, Cyclohexanon, Cyclopentanon oder insbesondere N-Methylpyrrolidon oder y-Butyrolacton oder auch chlorierte aliphatische Kohlenwasserstoffe wie 1,2-Dichlorethan oder insbesondere Methylenchlorid.

Die Dicke der Beschichtung kann je nach Anwendung in weiten Bereichen variieren; zweckmässig beträgt sie zwischen 5 μm und 200 μm, bevorzugt zwischen 10 μm und 100 μm.

Nach Applikation und Trocknen erhält man eine Beschichtung mit verbesserter Lösungsmittelbeständigkeit, die sich durch eine sehr gute Haftung auf Metallen auszeichnet.
Der Trocknungsvorgang wird im allgemeinen bei erhöhter Temperatur, die je nach Art des verwendeten Lösungsmittels zwischen ca. 120 °C und ca. 260 °C betragen kann, und gegebenenfalls unter IR-Bestrahlung durchgeführt.

Die Herstellung der erfindungsgemässen Laminate aus mit Polyethersulfon/Epoxidharz-Zusammensetzungen beschichteten Metallfolien erfolgt nach bekannten Verfahren, z.B. durch Verpressen mit einer ebenso hergestellten beschichteten Metallfolie oder mit einer unbeschichteten Metallfolie unter Druck, beispielsweise 1-24 MPa, in der Regel zwischen 180 °C und 300 °C. Die Verarbeitungstemperatur richtet sich einerseits nach der Glasübergangstemperatur des Polyarylenethers und andererseits nach der thermischen Stabilität des verwendeten Epoxids.

Gegenstand der vorliegenden Erfindung ist somit auch ein Verfahren zur Herstellung von Laminaten, dadurch gekennzeichnet, dass man eine mit einer Polyethersulfon/Epoxid-Zusammensetzung beschichtete Metallfolie mit einer unbeschichteten Metallfolie oder mit einer oder mehreren mit einer Polyethersulfon/Epoxid-Zusammensetzung beschichteten Metallfolie unter Druck zwischen 180 und 300 °C verpresst.

Vorzugsweise werden dabei zwei einseitig mit einer Polyethersulfon/EpoxidZusammensetzung beschichtete Metallfolien mit der beschichteten Seite zueinander unter Druck zwischen 180 und 300 °C verpresst.

Die auf diese Weise hergestellten Laminate sind Materialien, die die guten mechanischen Eigenschaften der Polyethersulfone aufweisen und sich durch verbesserte Lösungsmittelbeständigkeit und sehr hohe Haftfestigkeiten auszeichnen.
Eine bevorzugte Anwendung der erfindungsgemässen Laminate, die sehr flexibel sind und mehrmals ohne Bruch gefaltet werden können, ist die Herstellung von elektronischen Schaltungen.

I. Synthese der Polyethersulfone

I.1. PES 1: Polyethersulfon-Copolymeres aus 4,4'-Dihydroxydiphenylsulfon, 4,4'-Dihydroxybenzophenon und 4,4'-Dichlordiphenylsulfon

Ein Gemisch aus 17,18 g (0,0802 mol) 4,4'-Dihydroxybenzophenon, 0,3210 mol 4,4'-Dihydroxydiphenylsulfon, 58,1 g wasserfreiem Kaliumcarbonat, 318 g Diphenylsulfon und 100 g Xylol wird in einem Planschliffkolben mit Rührer unter Stickstoff bis auf eine Badtemperatur von 200 °C erhitzt, wobei eine Xylol/Wasser-Mischung abdestilliert. Der Destillationsvorgang wird nach etwa 1,5 h durch kurzzeitiges (ca. 10min) Anlegen eines Vakuums von ungefähr 1 mbar abgeschlossen. Anschliessend werden unter Stickstoff 114,86 g (0,4000 mol) 4,4'-Dichlordiphenylsulfon zu der Reaktionsmischung gegeben. Die Temperatur wird auf 250 °C erhöht und eine Stunde lang beibehalten. Danach wird die Temperatur für eine Stunde auf 275 °C und schliesslich für 4 h 15 min auf 280 °C angehoben. Die Reaktionsmischung zeigt dabei mit fortschreitender Reaktionszeit eine deutliche Viskositätszunahme.
Nach kurzem Abkühlen wird die Reaktionsmischung dem Kolben entnommen und nach Erstarren pulverisiert. Zur Isolierung des Polymeren wird das Gemisch mit Wasser unter Zusatz von Essigsäure, anschliessend mit Wasser und schliesslich mit einem Wasser/Aceton-Gemisch (1:4) extrahiert. Das so gereinigte Polymere wird danach im Vakuumtrockenschrank bis zu einer Temperatur von 240 °C getrocknet. Das auf diese Weise hergestellte Polyethersulfon-Copolymere besitzt eine reduzierte Viskosität (bestimmt durch Messung von 1 g Polymeren in 100 ml N-Methylpyrrolidon bei 25 °C) von 0,62 dl/g und einen OH-Endruppengehalt von 39 μval/g.

I.2. PES 2: Polyethersulfon-Copolymeres aus 4,4'-Dihydroxydiphenylsulfon, Hydrochinonund 4,4'-Dichlordiphenylsulfon

Analog zu Beispiel I. 1. wird ein Polyethersulfon-Copolymeres aus 0,3408 mol 4,4'-Dihydroxydiphenylsulfon, 0,0603 mol Hydrochinon, 0,4000 mol 4,4-Dichlordiphenylsulfon und 0,4200 mol Kaliumcarbonat (Reaktionsbedingungen: 1 h/250 °C, 1 h/275 °C, 4 h/280 °C) mit einer reduzierten Viskosität von 0,65 dl/g und einem OH-Endgruppengehalt von 10 μval/g synthetisiert.

I.3. PES 3: Polyethersulfon aus 4,4′-Dihydroxybiphenyl und 4,4′-Dichlordiphenylsulfon

Analog zu Beispiel I. 1. wird ein Polyethersulfon aus 0,1000 mol 4,4′-Dihydroxybiphenyl, 0,1011 mol 4,4′-Dichlordiphenylsulfon und 0,1051 mol Kaliumcarbonat (Reaktionsbedingungen: 1 h/226 °C, 1 h/258 °C, 1 h/278 °C) mit einer reduzierten Viskosität von 0,43 dl/g und einem OH-Endgruppengehalt von 46 µval/g synthetisiert.

I.4. PES 4: Polyethersulfon-Copolymeres aus 4,4′-Dihydroxydiphenylsulfon, 4,4′-Dihydroxybiphenyl und 4,4′-Dichlordiphenylsulfon

Analog zu Beispiel I. 1. wird ein Polyethersulfon-Copolymeres aus 0,3811 mol 4,4′-Dihydroxydiphenylsulfon, 0,0201 mol 4,4′-Dihydroxybiphenyl, 0,4000 mol 4,4-Dichlordiphenylsulfon und 0,4200 mol Kaliumcarbonat (Reaktionsbedingungen: 1 h/250 °C, 1 h/275 °C, 4 h/280 °C) mit einer reduzierten Viskosität von 0,71 dl/g und einem OH-Endgruppengehalt von 44 µval/g synthetisiert.

## II. Applikationsbeispiele

In den Formulierungen der nachfolgenden Beispiele werden die Polyethersulfone PES 1-4 sowie das kommerziell erhältliche Victrex® 5003 P (ICI) enthaltend wiederkehrende Einheiten der Struktur

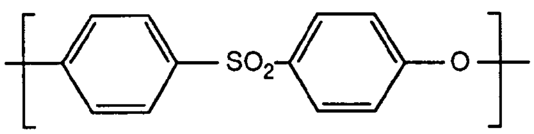

mit einer reduzierten Viskosität (1 g in 100 ml NMP) von 0,64 dl/g und einem OH-Endgruppengehalt von 60 µval/g eingesetzt.

Folgende Epoxidharze werden verwendet:

Epoxidharz 1: Bisphenol-A-diglycidylether mit einem Epoxidgehalt von 5,26-5,38 val/kg
Epoxidharz 2: Triglycidylisocyanurat mit einem Epoxidgehalt von 9,3-10,0 val/kg
Epoxidharz 3: N,N,N′,N′-Tetraglycidyl-4,4′-diaminodiphenylmethan mit einem Epoxidgehalt von 8,7-9,1 val/kg
Epoxidharz 4: Bisphenol-F-diglycidylether mit einem Epoxidgehalt von 5,55-5,95 val/kg
Epoxidharz 5: o,o′-Diallylbisphenol-A-diglycidylether mit einem Epoxidgehalt von 4,6 val/kg

### Beispiel 1 und Vergleichsbeispiel A:

Beispiel 1:

12,50 g Victrex® 5003 P
0,63 g Epoxidharz 1
75,00 g Methylenchlorid

Vergleichsbeispiel A:

15,00 g Victrex® 5003 P
85,00 g Methylenchlorid

Zur Bestimmung der Kupferhaftung wird eine Kupferfolie (Stärke 35 µm, NT-TW der Fa. Circuit Foils) mit einem Nassfilm von 200 µm der o.a. Zusammensetzungen auf der Behandlungsseite beschichtet. Nach einer Abdunstzeit von 15 min bei Raumtemperatur wird die Kupferfolie in einen Umluftofen von 50 °C gelegt. Die Temperatur wird auf 120 °C gesteigert, und die Probe wird bei dieser Temperatur 30 min getrocknet. Zwei solcherart getrocknete Kupferfolien werden mit der Beschichtung zueinanderliegend in eine 260 °C heisse Presse eingefahren. Nach einer Kontaktzeit wird der Druck auf 4-5 MPa erhöht. Nach einer Presszeit von 15 min wird unter Druck auf eine Temperatur unter 150 °C abgekühlt, und das Laminat wird anschliessend entnommen. Nach Herausätzen der Probestreifen wird die Kupferhaftung ermittelt. Zur Ermittlung der Flexibilität wird nach der gleichen Vorschrift gearbeitet, nur dass anstelle der zweiten beschichteten Kupferfolie eine Kupferfolie mit

Trennschicht auf der Glanzseite verwendet wird.
"Flex-life" = Zahl der Faltungen bis zum Bruch des Laminats, bestimmt mittels Universal-Model 2 FDF Flex Ductility Tester mit Zuggewicht 224 g und 2 mm Dorn.

Tabelle 1:

| Beispiel | 1 | A |
|---|---|---|
| Kupferhaftung (N/cm)<br>bei Raumtemperatur<br>bei 150 °C | <br>25 - 26<br>22 - 23 | <br>13 - 14<br>10 - 11 |
| Flex-life (Zyklen)<br>(Mittelwert aus 4 Messungen) | 292 | 276 |
| Materialdicke (μm) | 75 - 80 | 65 - 70 |

Aus den Werten der Tabelle 1 ist ersichtlich, dass das erfindungsgemässe Laminat gemäss Beispiel 1 eine wesentlich bessere Haftung und eine bessere Flexibilität als das Vergleichslaminat A aufweist, das keinen Epoxidanteil enthält.

Die verbesserte Lösungsmittelbeständigkeit der erfindungsgemässen Laminate zeigt das folgende Beispiel 2 und das Vergleichsbeispiel B.

Beispiel 2:

Auf eine Kupferfolie wird eine Lösung, enthaltend 23,75 g Victrex 5003 P, 1,25 g Epoxidharz 1 und 75 g N-Methylpyrrolidon, mittels einer Lackhantel (200 μm) aufgetragen und im Umluft-Lacktrockenschrank unter IR-Bestrahlung getrocknet (Umluft-Temperatur: 180 °C, 45 min, IR-Lampe: Heraeus Modell MMS 1200). Die Polymerschicht eines unter diesen Bedingungen hergestellten Laminates (Flex-life: 294, Mittelwert aus 5 Messungen) wird durch einstündiges Eintauchen in Methylenchlorid nicht gelöst.

Vergleichsbeispiel B:

Analog Beispiel 2 wird eine Lösung von 25 g Victrex®5003 P in 75 g N-Methylpyrrolidon ohne Epoxidharz verwendet. Das Polymere ist nach einstündigem Eintauchen in Methylenchlorid nahezu vollständig aufgelöst.

Beispiele 3-8:

Die in der Tabelle 2 angegebenen Polymermischungen werden als 20 %ige Lösung in N-Methylpyrrolidon mit einer Schichtdicke von 200 μm auf eine Kupferfolie (Stärke 35 μm, NT-TW der Fa. Circuit Foils) aufgetragen und anschliessend 30 min bei 170 °C und 60 min bei 240 °C im Umlufttrockenschrank getrocknet. Es ergeben sich die in der Tabelle 2 angegebenen Eigenschaftswerte.

Tabelle 2:

| Beispiel | Zusammensetzung | Flex-Life [1.)] (Zyklen) | Material-dicke [μm] | Kupferhaftung bei Raumtemp. [N/cm] |
|---|---|---|---|---|
| 3 | 90 Gew.-Teile PES 1<br>10 Gew.-Teile Epoxidharz 2 | 307 | 75 | 20,0 |
| 4 | 95 Gew.-Teile PES 2<br>5 Gew.-Teile Epoxidharz 1 | 338 | 70 | 17,3 |
| 5 [2.)] | 95 Gew.-Teile PES 2<br>5 Gew.-Teile Epoxidharz 1 | n.b. [3.)] | 70 | 18,5 - 24,6 |
| 6 | 47,5 Gew.-Teile PES 2<br>47,5 Gew.-Teile PES 3<br>4 Gew.-Teile Epoxidharz 1<br>1 Gew.-Teile Epoxidharz 3 | 360 | 55 - 65 | 14,6 |
| 7 | 95 Gew.-Teile PES 4<br>5 Gew.-Teile Epoxidharz 1 | 359 | 60 - 65 | 18,5 |
| 8 | 90 Gew.-Teile PES 1<br>10 Gew.-Teile Epoxidharz 4 | 326 | 75 - 80 | 18,1 |

[1.)] Mittelwert aus 4 Messungen

[2.)] zusätzlich 15 min bei 260 °C verpresst

[3.)] n.b.: nicht bestimmt

Beispiele 9-11:

Die in der Tabelle 3 angegebenen Polymermischungen werden als 25 %ige Lösung in N-Methylpyrrolidon mit einer Schichtdicke von 200 μm mittels einer Lackhantel auf eine Kupferfolie (Stärke 35 μm, NT-TW der Fa. Circuit Foils) aufgetragen und im Umluft-Lacktrockenschrank unter IR-Bestrahlung getrocknet (Umluft-Temperatur: 240 °C, 60 min, IR-Lampe: Heraeus Modell MMS 1200). Ein Teil der beschichteten Folie (Materialdicke ca. 55 μm) wird in 1 cm breite Streifen zerschnitten. Aus diesen Streifen wird das Flex-Life bestimmt. An einem weiteren Folienteil (Grösse 8 cm x 8 cm) wird die Gewichtszunahme nach 1 h Lagerung in Methylenchlorid gemessen.

Tabelle 3:

| Beispiel | Zusammensetzung | Flex-Life [1.)] (Zyklen) | Gewichtszunahme nach 1 h Lagerung in $CH_2Cl_2$ [%] |
|---|---|---|---|
| 9 | 97,5 Gew.-Teile Victrex 5003 P<br>2,5 Gew.-Teile Epoxidharz 5 | 347 | + 0,3 |
| 10 | 95 Gew.-Teile Victrex 5003 P<br>5 Gew.-Teile Epoxidharz 5 | 341 | + 3,3 |
| 11 | 90 Gew.-Teile Victrex 5003 P<br>10 Gew.-Teile Epoxidharz 5 | 301 | + 10,3 |

[1.)] Mittelwert aus 6 Messungen

**Patentansprüche**

**1.** Laminate enthaltend mindestens eine Metallfolie und mindestens eine darauf direkt aufgebrachte Kunststoffschicht aus einer Zusammensetzung, die 2-40 Gew.% mindestens eines mehrfunktionellen Epoxids mit mindestens zwei direkt an ein oder mehrere Sauerstoff-, Stickstoff- oder Schwefelatome gebundenen Glycidylgruppen und 98-60 Gew.% mindestens eines vorwiegend OH-terminierten Polyethersulfons mit einem Hydroxylgruppengehalt von mindestens 10 μval/g, enthaltend wiederkehrende Strukturelemente der Formel (I), enthält

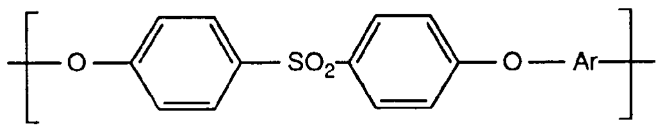 (I),

worin Ar für einen zweiwertigen aromatischen Rest der Formeln (IIa) bis (IIh) steht

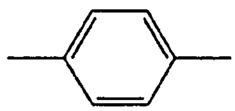 (IIa), 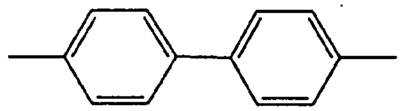 (IIb),

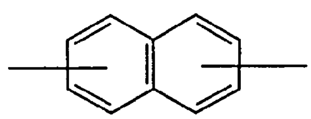 (IIc), 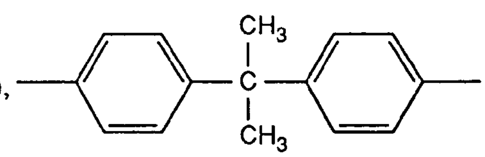 (IId),

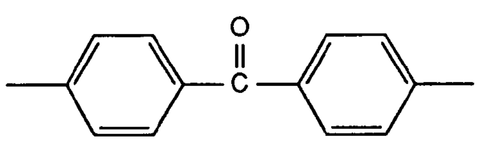 (IIe), 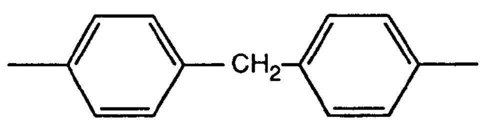 (IIf),

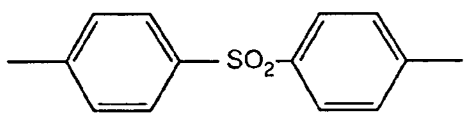 (IIg),

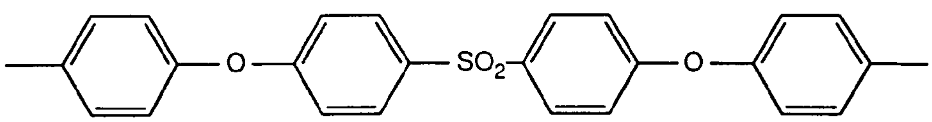 (IIh),

und worin die aromatischen Ringe der Strukturelemente gemäss Formel (I) oder (IIa)-(IIh) unsubstituiert sind oder durch eine oder mehrere ($C_1$-$C_6$)-Alkylgruppen, ($C_1$-$C_6$)-Alkoxygruppen oder Halogenatome substituiert sind.

**2.** Laminate gemäss Anspruch 1, worin die Polyethersulfon/Epoxid-Zusammensetzung 4-20 Gew.%, bevorzugt 5-15 Gew.%, eines mehrfunktionellen Epoxids und 96-80 Gew.%, bevorzugt 95-85 Gew.%, eines Polyethersulfons enthält.

**3.** Laminate gemäss Anspruch 1, worin Ar einen Rest der Formeln (IIa), (IIb), (IIc) oder (IIg) darstellt.

4. Laminate gemäss Anspruch 1, worin Ar ein Rest der Formel (IIg) ist.

5. Laminate gemäss Anspruch 1, worin die aromatischen Ringe der Strukturelemente (I) und (IIa)-(IIh) unsubstituiert sind.

6. Laminate gemäss Anspruch 1, worin das Epoxid ausgewählt wird aus der Gruppe bestehend aus Bisphenol-A-diglycidylether, Bisphenol-F-diglycidylether, Bisphenol-S-diglycidylether, Resorcindiglycidylether, N,N,O-Triglycidyl-p-aminophenol, N,N,O-Triglycidyl-m-aminophenol, Triglycidylisocyanurat, Tetraglycidyl-4,4′-diaminodiphenylmethan und Tetra(p-glycidyloxyphenyl)ethan.

7. Laminate gemäss Anspruch 1, worin das Epoxid Bisphenol-A-diglycidylether, Bisphenol-F-diglycidylether, Triglycidylisocyanurat oder N,N,N′,N′-Tetraglycidyldiaminodiphenylmethan ist.

8. Laminate gemäss Anspruch 1, worin das Epoxid o,o′-Diallylbisphenol-A-diglycidylether ist.

9. Laminate gemäss Anspruch 1, worin die Metallfolie eine Kupferfolie ist.

10. Verfahren zur Herstellung von Laminaten gemäss Anspruch 1, dadurch gekennzeichnet, dass eine Polyethersulfon/Epoxid-Zusammensetzung gemäss Anspruch 1, gelöst in einem organischen Lösungsmittel, auf eine Metallfolie aufgebracht und bei Temperaturen zwischen 100 °C und 300 °C, gegebenenfalls unter IR-Bestrahlung, getrocknet wird. getrocknet wird.

11. Verfahren zur Herstellung von Laminaten gemäss Anspruch 1, dadurch gekennzeichnet, dass man eine mit einer Polyethersulfon/Epoxid-Zusammensetzung gemäss Anspruch 1 beschichtete Metallfolie mit einer unbeschichteten Metallfolie oder mit einer oder mehreren mit einer Polyethersulfon/Epoxid-Zusammensetzung gemäss Anspruch 1 beschichteten Metallfolie unter Druck zwischen 180 und 300 °C verpresst.

12. Verfahren gemäss Anspruch 11, dadurch gekennzeichnet, dass man zwei einseitig mit einer Polyethersulfon/Epoxid-Zusammensetzung gemäss Anspruch 1 beschichtete Metallfolien mit der beschichteten Seite zueinander unter Druck zwischen 180 und 300 °C verpresst.